# FASCICULE DE BREVET EUROPEEN

(11) **EP 0 392 905 B1**
(45) Date de publication et mention de la délivrance du brevet: **16.03.1994**
(21) Numéro de dépôt: 90400949.5
(22) Date de dépôt: 06.04.1990
(51) Int. Cl.: H05K 5/06

(54) **Boîtiers étanches de protection pour circuits électriques ou électroniques**
Dichte Schutzgehäuse für elektrische oder elektronische Schaltungen
Sealed protecting casings for electric or electronic circuits

(30) Priorité: 11.04.1989 FR 8904726
(43) Date de publication de la demande: 17.10.1990
(73) Titulaire: THOMSON-BRANDT ARMEMENTS, 92516 Boulogne-Billancourt (FR)
(72) Inventeur: Bansard, Joel, F-92045 Paris la Défense (FR); Boucard, Jean, F-92045 Paris la Défense (FR); Novak, Bernard, F-92045 Paris la Défense (FR)
(74) Mandataire: Benoit, Monique

(56) Documents cités:
- DE-A- 2 652 262
- DE-A- 3 311 252
- DE-A- 3 402 256
- DE-A- 3 731 576
- DE-U- 8 416 902

## Description

La présente invention concerne des boîtiers hermétiques destinés à protéger des circuits électriques ou électroniques. Elle concerne plus particulièrement de tels boîtiers pour des circuits dont les conditions d'environnement telles que pression, électromagnétisme, etc., sont susceptibles de variations brutales et importantes.

Des problèmes de protection de circuits se posent notamment dans le domaine de l'équipement d'engins lancés à haute altitude, tels que des projectiles ou des missiles. par exemple, certains dispositifs de mise à feu nécessitent, pour des raisons de sécurité et de fiabilité, des systèmes de commande à tension élevée, qui sont sensibles aux faibles pressions et doivent, par conséquent, être placés à l'intérieur d'enceintes que l'on qualifie ici d'hermétiques, c'est à dire d'enceintes où la pression reste pratiquement invariable dans les conditions d'utilisation. Généralement, pour ces mêmes systèmes, une protection électromagnétique est requise, ou tout au moins préférable.

Par ailleurs, dans ce domaine de l'armement comme dans beaucoup d'autres, un problème également important réside dans l'utilisation optimale de l'espace, conduisant souvent à la nécessité de concevoir des agencements aux formes compliquées, notamment lorsqu'il s'agit de blocs fonctionnels particuliers renfermant un assemblage de composants.

On connaît d'après le document EP-A- 0.250.334 un boîtier, renfermant les circuits d'un coupleur de câbles, pouvant être réalisé en matière plastique métallisée, mais il n'est pas prévu de le rendre hermétique.

Le but de l'invention est de prévoir un boîtier pour contenir un ensemble de composants qui permette de résoudre facilement ces différents problèmes.

L'invention a pour objet un boîtier hermétique de protection pour des circuits électriques ou électroniques comprenant deux parties, boîtier caractérisé en ce que les parois des deux parties du boîtier comportent un revêtement plastique recouvert extérieurement par le revêtement métallique, les deux parties étant un fond et un couvercle dont les bords ont des formes complémentaires pour s'encastrer l'un dans l'autre, un cordon de soudure étant disposé entre ces bords et chauffé à la fermeture du boîtier pour en assurer l'herméticité après fusion de ce cordon.

Le fait que le boîtier selon l'invention soit au moins partiellement en matière plastique offre plusieurs avantages parmi lesquels : facilité de réaliser les formes de boîtier les plus diverses ; facilité de fixation et d'isolation mutuelle des composants ; possibilité de réaliser des plages de circuits imprimés sur les faces internes et externes du boîtier.

Quant au revêtement métallique externe, il confère une quasi-herméticité en collaboration avec le joint de soudure étanche, qu'il est difficile d'obtenir avec la matière plastique seule. Il forme, en outre, un écran électromagnétique efficace, aussi bien de l'extérieur vers l'intérieur que vice-versa.

L'invention sera mieux comprise à l'aide des explications qui vont suivre et des dessins annexés, dans lesquels :
- la figure 1 est une vue en coupe d'un boîtier selon l'invention ;
- la figure 2 est une vue en coupe partielle illustrant une forme de réalisation de jonction étanche entre parties constitutives d'un boîtier selon l'invention ;
- la figure 3 illustre une autre forme de jonction étanche ;
- les figures 4 à 6 sont des vues partielles en coupe illustrant le montage dans une paroi de boîtier selon l'invention de composants électriques traversants ;
- les figures 7 et 8 sont respectivement une vue en coupe et une vue en plan illustrant le blindage d'un câble de connexion à l'extérieur du boîtier ; et
- la figure 9 est une vue schématique en coupe d'un boîtier selon l'invention, illustrant une application où le boîtier contient un détonateur ou inflammateur à commande électrique, ainsi que son circuit de commande.

Dans les dessins et dans la description qui va suivre, on utilisera partout les mêmes références pour désigner les mêmes éléments.

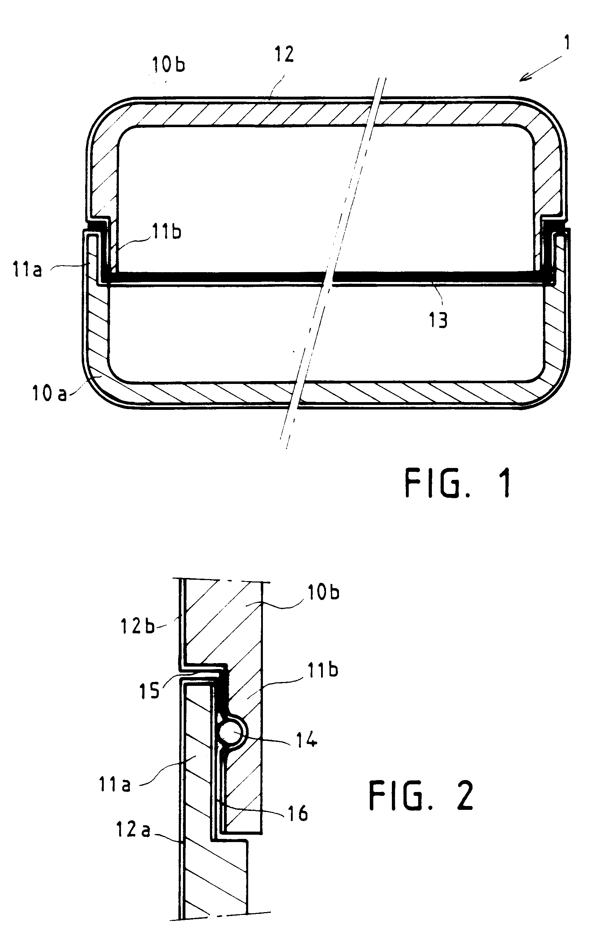

Dans sa forme la plus usuelle, le boîtier selon l'invention est formé de deux parties, tel le boîtier 1 partiellement représentée à la figure 1 qui comprend un fond 10a et un couvercle 10b, dont les bords libres, respectivement 11a et 11b, ont des formes complémentaires pour s'encastrer l'un dans l'autre.

Selon l'invention, le fond et le couvercle du boîtier sont constitués chacun d'une paroi présentant un revêtement plastique 10 recouvert extérieurement d'un revêtement métallique 12, par exemple en nickel.

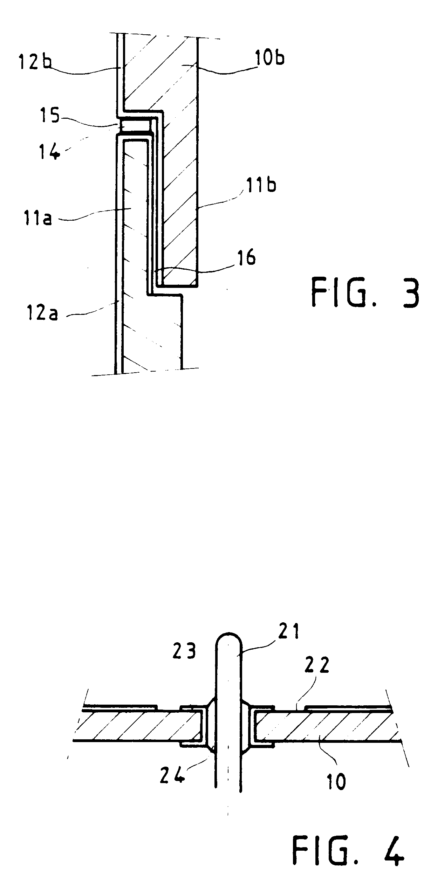

Diverses façons de réaliser un scellement étanche 13 entre le fond et le couvercle du boîtier 1 sont illustrées aux figures 2 et 3. Les revêtements 12a et 12b sur le fond 10a et le couvercle 10b sont prolongés de manière à recouvrir, au moins partiellement, les surfaces des bords 11a et 11b destinées à venir en contact l'une contre l'autre. Sur l'une de ces surfaces, une gorge périphérique est prévue, figure 2, dans laquelle est inséré un fil de soudure 14, par exemple en étain. En variante, le cordon de soudure périphérique peut se présenter sous la forme d'une bande, appliquée directement sur la face de l'un ou l'autre des bords 11a et 11b, par exemple aux endroits repérés en 15, comme illustré à la figure 3, ou en 16. La chaleur nécessaire à la fusion du cordon de soudure peut être apportée par exemple par induction à haute fréquence ou en phase vapeur.

Les circuits à l'intérieur du boîtier sont réalisés classiquement sur des cartes, et/ou directement sur les faces internes du boîtier, du fait des qualités diélectriques de la matière plastique dont sont constituées ses parois.

Un développement important de l'invention concerne les connexions entre l'intérieur du boîtier et l'extérieur. Selon l'invention, ces connexions sont réalisées au moyen de composants électriques montés traversants dans les parois du boîtier. Plus précisément, les composants sont engagés dans des trous métallisés pratiqués dans les parois du boîtier, puis fixés dans les trous au moyen d'une soudure assurant en outre l'étanchéité. Certaines de ces connexions, parmi les plus courantes, sont représentées aux figures 4 à 6.

La figure 4 illustre le montage travers une paroi du boîtier d'une broche de connexion 21. A cet effet, une zone d'aire réduite 22 à la surface externe du revêtement plastique 10 est exempte de revêtement 12, au milieu de laquelle est pratiqué un trou métallisé 23. La broche 21 est engagée dans le trou 23, et fixée par une soudure 24 qui l'entoure totalement afin de garantir l'étanchéité.

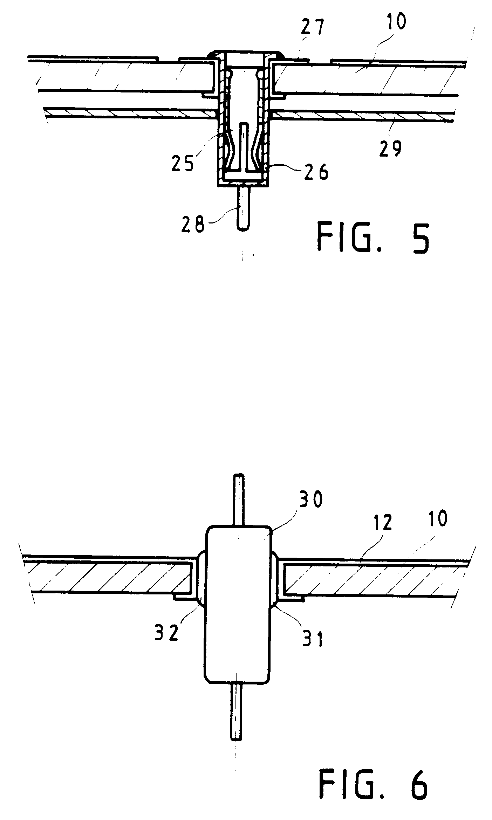

Pour le montage d'une pince de connexion telle que la pince 25 montrée à la figure 5, il est préférable de prévoir un élément supplémentaire, à savoir un fourreau étanche et conducteur 26 dans lequel la pince 25 est logée. Le fourreau 26, dont le bord présente une collerette, est engagé et soudé dans le trou métallisé 27, et c'est par son intermédiaire que la connexion est assurée à l'intérieur du boîtier, au moyen par exemple d'une broche 28 solidaire de son fond. En variante, et comme l'illustre également la figure 5, la liaison électrique à l'intérieur du boîtier peut être réalisée en engageant le fourreau conducteur 26 dans un trou de contact métallisé d'une carte de circuit imprimé 28 placée adjacente au revêtement plastique 10.

A la figure 6, un condensateur 30 est monté traversant dans une paroi du boîtier. Le condensateur 30 est métallisé extérieurement, de manière à être fixé dans le trou métallisé 31 au moyen d'une soudure étanche 32. A noter qu'ici, il n'y a pas nécessité de discontinuité électrique entre le trou métallisé 31 et le revêtement 12, de sorte que le revêtement métallique dudit trou peut être obtenu par prolongement du revêtement métallique 12 du revêtement plastique 10. D'autres composants, notamment des filtres peuvent être montés de la même façon que le condensateur 30.

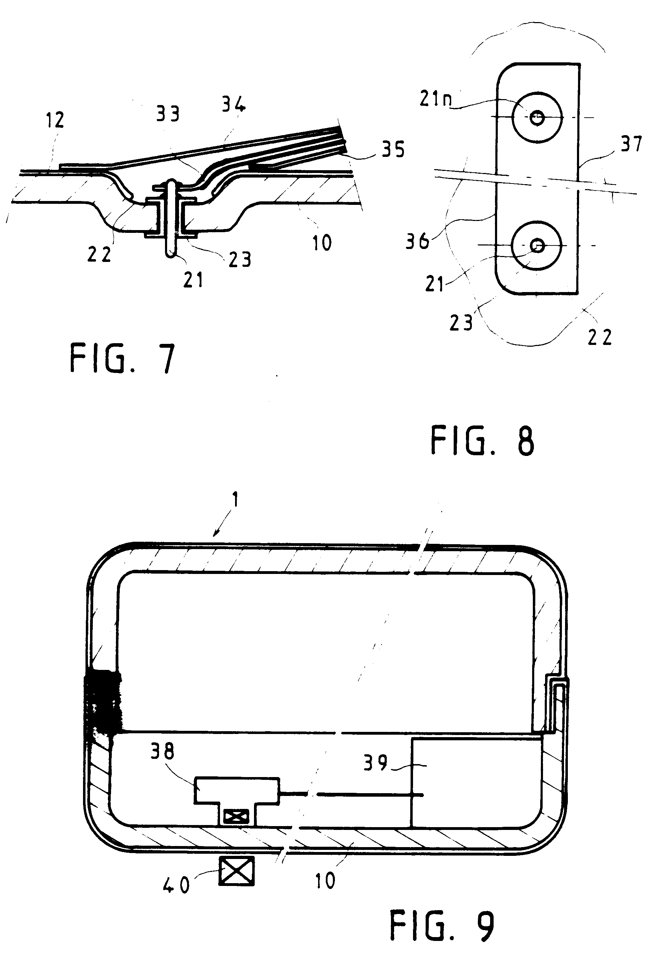

L'invention permet en outre des liaisons externes par câbles blindées, ceux-ci étant coaxiaux ou bien en nappe. Une liaison de ce type est représentée aux figures 7 et 8. A la figure 7, un conducteur externe 33 est relié à une broche de connexion 21 montée traversante dans une paroi de boîtier. Comme on l'a déjà précisé, une plage 22 est exempte de revêtement 12 autour du trou métallisé 23 de réception de la broche. Le conducteur 33 peut être unitaire, ou par exemple faite partie d'un ensemble formant une liaison multiple sous la forme d'un ruban souple, les autres conducteurs étant alors reliés à des composants tels que 21n adjacents à la broche 21, comme montré à la figure 8. A noter que dans ce cas, la plage 22 exempte de revêtement entoure alors l'ensemble des composants 21 à 21n. Le blindage montré consiste en une bande métallique supérieure 34 et une bande métallique inférieure 35, soudées respectivement d'un bout à l'autre le long des bords 36 et 37 de la plage 22, figure 8. Bien entendu, un tel blindage est réalisable quels que soient les composants traversants auxquels sont reliés les conducteurs externes. Ces liaisons par câbles blindés présentent le double intérêt d'être à très basse impédance et d'offrir une protection électromagnétique efficace en formant cage de Faraday.

Par ailleurs, comme on l'a mentionné précédemment, les caractéristiques diélectriques de la matière plastique constituant les parois du boîtier 1 permettent d'utiliser ses faces internes en tant que supports de circuits. De même, des plages de circuits, en relation avec des circuits ou composants à l'intérieur du boîtier par des composants montés traversants, peuvent être prévues dans des portions de surfaces externes exemptes de revêtement, ces circuits comportant par exemple des plots de test.

Pour certaines applications, une partie du volume interne du boîtier peut servir à loger d'autres éléments que des circuits, notamment s'il est intéressant de profiter de conditions d'environnement privilégiées pour ces éléments. Un exemple illustrant ceci est montré schématiquement à la figure 9. Dans le boîtier 1, se trouve un détonateur ou inflammateur 38 relié à un circuit de commande à tension élevée 39, lui-même relié avec l'extérieur par des composants montés traversants, non représentés. L'inflammateur ou détonateur 38 peut servir, par exemple, à initier une charge pyrotechnique 40 placée face à lui de l'autre côté de la paroi du boîtier. En raison de la résistance mécanique suffisamment faible du revêtement plastique 10, dont l'épaisseur peut être inférieure à 1 mm, le détonateur ou inflammateur 38 agira par transmission de l'onde de détonation à travers la paroi.

## Revendications

1. Boîtier hermétique de protection pour des circuits électriques ou électroniques comprenant deux parties, caractérisé en ce que les parois des deux parties du boîtier comportent un revêtement plastique (10) recouvert extérieurement par le revêtement métallique (12), les deux parties étant un fond (10a) et un couvercle dont les bords (11a, 11b) ont des formes complémentaires pour s'encastrer l'un dans l'autre, un cordon de soudure étant disposé entre ces bords et chauffé à la fermeture du boîtier pour en assurer l'herméticité après fusion de ce cordon.

2. Boîtier hermétique selon la revendication 1, caractérisé en ce que les deux parties sont réunies par un joint de soudure positionné dans une gorge périphérique réalisée sur l'une des surfaces des bords (11a, 11b).

3. Boîtier hermétique selon la revendication 1, caractérisé en ce que les deux parties sont réunies par un joint de soudure sous forme de bande positionnée sur la face de l'un ou l'autre des bords (11a, 11b).

4. Boîtier selon l'une des revendications précédentes, caractérisé en ce que le cordon de soudure est chauffé par induction à haute fréquence.

5. Boîtier selon l'une des revendications 1 à 3, caractérisé en ce que le cordon de soudure est chauffé en phase vapeur.

6. Boîtier étanche selon l'une des revendications précédentes, caractérisé en ce qu'il comporte des moyens de traversée hermétique pour des moyens de connexion entre l'intérieur et l'extérieur.

7. Boîtier selon la revendication 6, caractérisé en ce que les connexions entre l'intérieur et l'extérieur sont établies par l'intermédiaire de composants (21, 27, 29) montés traversant de façon hermétique dans ses parois en matière plastique (10) recouverte d'un revêtement métallique (12).

8. Boîtier selon la revendication 7, caractérisé en ce que lesdits éléments traversant sont engagés dans des trous métallisés (23, 26, 30) pratiqués dans la paroi et fixés dans lesdits trous par un joint de soudure hermétique (24, 31).

9. Boîtier selon l'une des revendications précédentes, caractérisé en ce qu'au moins une de ses parois en matière plastique recouverte d'un revêtement métallique (12) présente extérieurement une zone exempte de revêtement (12) comportant un circuit imprimé relié avec l'intérieur.

10. Boîtier selon l'une des revendications précédentes, caractérisé en ce qu'il renferme un inflammateur ou détonateur (38) agissant par transmission de l'onde de détonation à travers la paroi, ou par percement de la paroi, causé par la production de gaz, pour initier une charge pyrotechnique (40) placée à l'extérieur.

## Patentansprüche

1. Hermetisch dichter Schutzbehälter für elektrische oder elektronische Schaltungen, der zwei Teile umfaßt, dadurch gekennzeichnet, daß die Wände der zwei Teile des Behälters einen Kunststoffüberzug (10) aufweisen, der an seiner Außenseite durch den Metallüberzug (12) bedeckt ist, wobei die beiden Teile ein Boden (10a) und ein Deckel sind, deren Ränder (11a, 11b) komplementäre Formen besitzen, um sich ineinanderzufügen, wobei zwischen diesen Rändern ein Lötwulst angeordnet ist, der beim Verschließen des Behälters erwärmt wird, um dadurch nach dem Schmelzen dieser Naht die hermetische Dichtheit zu gewährleisten.

2. Hermetisch dichter Behälter gemäß Anspruch 1, dadurch gekennzeichnet, daß die beiden Teile durch eine Lötverbindung vereinigt sind, die in einer Umfangsnut liegt, die in einer der Flächen der Ränder (11a, 11b) gebildet ist.

3. Hermetisch dichter Behälter gemäß Anspruch 1, dadurch gekennzeichnet, daß die beiden Teile durch eine Lötverbindung in Form eines Streifens vereinigt sind, welcher an der Fläche des einen oder des anderen der Ränder (11a, 11b) liegt.

4. Behälter gemäß einem der vorangehenden Ansprüche, dadurch gekennzeichnet, daß der Lötwulst mittels Hochfrequenzinduktion erwärmt wird.

5. Behälter gemäß einem der Ansprüche 1 bis 3, dadurch gekennzeichnet, daß der Lötwulst in die Dampfphase erwärmt wird.

6. Dichter Behälter gemäß einem der vorangehenden Ansprüche, dadurch gekennzeichnet, daß er hermetisch dichte Durchführungsmittel für Anschlußmittel zwischen innen und außen enthält.

7. Behälter gemäß Anspruch 6, dadurch gekennzeichnet, daß die Anschlüsse zwischen innen und außen über Bauelemente (21, 27, 29) gebildet sind, die so angebracht sind, daß sie auf hermetisch dichte Weise durch die von einem metallischen Überzug (12) bedeckten Wände aus Kunststoffmaterial (10) führen.

8. Behälter gemäß Anspruch 7, dadurch gekennzeichnet, daß die Durchführungselemente mit in der Wand ausgebildeten metallisierten Löchern (23, 26, 30) in Eingriff sind und in den Löchern durch einen hermetisch dichten Lötwulst (24, 31) befestigt sind.

9. Behälter gemäß einem der vorangehenden Ansprüche, dadurch gekennzeichnet, daß wenigstens eine der mit einem metallischen Überzug (12) bedeckten Wände aus Kunststoffmaterial an ihrer Außenseite eine Zone ohne Überzug (11) aufweist, die eine mit dem Inneren verbundene gedruckte Schaltung enthält.

10. Behälter gemaß einem der vorangehenden Ansprüche, dadurch gekennzeichnet, daß er einen Zünder oder eine Sprengkapsel (38) einschließt, die mittels der Fortpflanzung der Detonationswelle durch die Wand oder mittels des durch die Gasproduktion verursachten Durchstoßens der Wand wirkt, um eine außerhalb angeordnete pyrotechnische Ladung (40) zu zünden.

## Claims

1. A protective hermetic enclosure for electric or electronic circuits comprising two parts, characterized in that the walls of the two parts of the enclosure include a plastic coating (10) externally covered by the metallic coating (12), the two parts being a bottom (10a) and a cover whose rims (11a, 11b) have complementary forms in order to fit into each other, a bead of solder being arranged between the rims and heated on closing the enclosure in order to ensure a hermetic joint after fusion of such bead.

2. The hermetic enclosure as claimed in claim 1, characterized in that the two parts are connected by a joint of solder positioned in a peripheral channel made on one of the surfaces of the rims (11a, 11b).

3. The hermetic enclosure as claimed in claim 1, characterized in that the two parts are connected by a solder joint in the form of a strip positioned on the surface of either one of the rims (11a, 11b).

4. The enclosure as claimed in any one of the preceding claims, characterized in that the bead of solder is heated by high frequency induction.

5. The enclosure as claimed in any one of the claims 1 through 3, characterized in that the bead of solder is heated in a vapor phase.

6. The enclosure as claimed in any one of the preceding claims, characterized in that it comprises hermetic lead-through means for connection means between the inside and the outside.

7. The enclosure as claimed in claim 6, characterized in that the connections between the inside and the outside are established by the intermediary of components (21, 27, 29) mounted so as to extend hermetically through in the walls of plastic material (10) thereof covered by a metallic coating (12).

8. The enclosure as claimed in claim 7, characterized in that said elements extending through are fitted in metallized holes (23, 26, 30) made in the wall and are secured in the said holes by a hermetic solder joint (24, 31).

9. The enclosure as claimed in any one of the preceding claims, characterized in that at least one of the walls thereof of plastic material covered by a metallic coating (12) presents on the outside a zone free of coating (12) and comprising a printed circuit connected with the interior.

10. The enclosure as claimed in any one of the preceding claims, characterized in that it encloses an igniter or a detonator (38) acting by the transmission of the detonation wave through the wall, or by piercing the wall, caused by the production of gas in order to initiate a pyrotechnic charge (40) arranged on the outside.
